# EUROPÄISCHE PATENTSCHRIFT

(11) **EP 4 140 602 B1**
(45) Veröffentlichungstag und Bekanntmachung des Hinweises auf die Patenterteilung: **29.01.2025**
(21) Anmeldenummer: 22192027.5
(22) Anmeldetag: 24.08.2022
(51) Int. Cl.: B06B 1/02, B06B 3/02, G08B 3/00, G10K 7/00, G10K 11/00, H03F 3/183, H03F 3/21, H03F 1/02, H03G 3/00, B60Q 5/00, G10K 9/12

(54) **SONDERSIGNALANLAGE**
SPECIAL SIGNAL SYSTEM
SIGNALISATION SPÉCIALE

(30) Priorität: 30.08.2021 DE 202021104667 U
(43) Veröffentlichungstag der Anmeldung: 01.03.2023
(73) Patentinhaber: Haberl Electronic GmbH & Co. KG, 94424 Arnstorf (DE)
(72) Erfinder: Haberl, Christian, 94424 Arnstorf (DE); Dicklberger, Richard, 84385 Egglham (DE)
(74) Vertreter: Lichtnecker, Markus Christoph

(56) Entgegenhaltungen:
- EP-A1- 2 015 290
- EP-B1- 0 025 537
- AU-A- 3 531 678
- US-A- 6 130 605

## Beschreibung

Die Erfindung betrifft eine Sondersignalanlage, vorzugsweise einer Sirene und/oder eines Einsatzfahrzeugs, aufweisend zumindest einen Signaltreiber, vorzugsweise Lautsprecher, und wenigstens eine Tonendstufe.

Im Bereich der Signalanlagen für Fahrzeuge mit Sonderrechten, z.B. beim Rettungsdienst, der Polizei und/oder der Feuerwehr, werden überwiegend elektronische Sondersignalverstärker mit Hornlautsprechern verwendet. Es kommen jedoch auch Druckluftanlagen zum Einsatz.

Die elektronischen Sirenen weisen einen Niederfrequenz-Verstärker mit integriertem Signalgeber und einem oder mehreren Lautsprechern auf. Das Gesamtsystem bestehend aus Sondersignalverstärker und Lautsprecher unterliegt in Deutschland dem Zulassungsverfahren nach TA32/TA32a.

Hier ist der Mindestschalldruck (110 dBA in 3,5 m Abstand), die zeitliche Abfolge (ein Zyklus TA/TÜ/TA/TÜ), die Gesamtlaufzeit (3 s), die tiefe Abstimmung (TA) (0,75 s), die hohe Abstimmung (TÜ) (0,75 s) und das Frequenzspektrum (im Bereich von 1000 Hz bis 4000 Hz soll mindestens einer der harmonischen Obertöne jedes Klanges den unbewerteten Schallpegel von 104 dB - bezogen auf p0 = 20 µ/m² - überschreiten) des akustischen Signals definiert.

Elektronische Sondersignalanlagen haben im Vergleich zu Druckluftanlagen Nachteile beim Erreichen des maximalen Schalldrucks bzw. bei der Wahrnehmbarkeit durch andere Verkehrsteilnehmer.

Um diesen Nachteilen entgegenzuwirken, darf das Warnsignal jedoch nur soweit verändert werden, dass es noch den Anforderungen der TA32/TA32a entspricht.

EP 0 025 537 B1, AU 35316 78 A, US 6 130 605 A und EP 2 015 290 A1 offenbaren Sirenen/Sondersignalanlagen mit abwechselnden Tonfolgen in einem Zyklus. Unterschiedliche Betriebsspannungen werden darin jedoch nicht zur zyklischen AM-Modulation der Lautstärke herangezogen.

Es ist eine Aufgabe der Erfindung, eine Sondersignalanlage zu schaffen, welche einen hohen maximalen Schalldruck und/oder eine hohe Wahrnehmbarkeit aufweist.

Die Lösung dieser Aufgabe erfolgt durch eine Sondersignalanlage mit den Merkmalen des Anspruchs 1.

Bei der erfindungsgemäßen Sondersignalanlage handelt es sich vorzugsweise um eine Sondersignalanlage einer Sirene und/oder eines Einsatzfahrzeugs, z.B. der Feuerwehr, des Rettungsdienstes, eines Notarztes und/oder der Polizei.

Die, vorzugsweise elektronische, Sondersignalanlage weist zumindest einen Signaltreiber, vorzugsweise Lautsprecher, auf. Bei dem Signaltreiber kann es sich beispielsweise um einen Hornlautsprecher handeln. Es können auch mehrere, z.B. zwei, drei, vier oder mehr, Signaltreiber vorgesehen sein.

Vorzugsweise weist die Sondersignalanlage einen Niederfrequenz-Verstärker mit integriertem Signalgeber und einem oder mehreren der Signaltreiber auf.

Die Sondersignalanlage weist wenigstens eine Tonendstufe und eine Steuerungsvorrichtung auf.

Die Steuerungsvorrichtung ist dazu ausgebildet, zur AM-Modulation der Lautstärke eine Betriebsspannung der Tonendstufe nach einem Zyklus zu verändern. Der Zyklus umfasst wenigstens zwei aufeinander folgende, sich in der Höhe unterscheidende Töne.

Die Töne, welche auch als Klänge oder Abstimmung bezeichnet werden, sind vorzugsweise über die Signaltreiber ausgebbar bzw. werden ausgegeben.

Die tiefe und hohe Abstimmung stehen vorzugsweise in einem Verhältnis 1:1,333. Die Grundfrequenzen der hohen und tiefen Abstimmung können z.B. im Bereich von 360 Hz bis 630 Hz liegen.

Der Zyklus kann wenigstens eine Abfolge mit einer tiefen Abstimmung (TA) und einer hohen Abstimmung (TÜ) umfassen bzw. daraus bestehen. Als Zyklus sind z.B. Abfolgen wie TA TÜ oder TA TÜ TA TÜ denkbar. Auch Abfolgen wie TÜ TA oder TÜ TA TÜ TA können einem Zyklus entsprechen.

Ein Tonfolgesignal besteht aus zyklisch wiederkehrenden Klangfolgen bzw. aus einer hohen (TÜ) und einer tiefen (TA) Abstimmung.

Ein Zyklus kann beispielsweise 3 s dauern. Zwischen zwei Zyklen kann vorzugsweise eine Pause vorgesehen sein. Alternativ kann nach einem Zyklus ohne Unterbrechung der nächste Zyklus folgen.

Durch die zyklische Veränderung der Tonhöhe ist das Signal weniger monoton und es wirkt auffälliger. Zugleich steigt der Schalldruck um beispielsweise 3 dB gegenüber einer herkömmlichen Anlage, da die Leistung am Lautsprecher bei einem Zyklus doppelt so hoch ist wie beim darauffolgenden Zyklus.

Die Sondersignalanlage weist somit einen hohen maximalen Schalldruck und/oder eine hohe Wahrnehmbarkeit auf.

Die Schlüsselparameter der signaltechnischen Zulassung werden ferner nicht beeinflusst. Für den Schalldruck ist hier nur ein Mindestwert zu erreichen. Der A-bewertete Schalldruckpegel muss in der Richtung der größten Schallabstrahlung in 3,5 m Abstand im reflexionsfreien Raum für jeden der beiden Einzelklänge mindestens 110 dB betragen.

Weiterbildungen der Erfindung sind auch den abhängigen Ansprüchen, der Beschreibung sowie den beigefügten Zeichnungen zu entnehmen.

Gemäß einer Ausführungsform umfasst ein Zyklus wenigstens oder genau einen tiefen und einen darauf folgenden hohen Ton.

Alternativ kann ein Zyklus wenigstens oder genau einen hohen und einen darauf folgenden tiefen Ton umfassen.

Als Zyklus ist z.B. eine Abfolge wie TA TÜ denkbar. Auch eine Abfolge wie TÜ TA kann einem Zyklus entsprechen.

Nach einer weiteren Ausführungsform umfasst ein Zyklus wenigstens oder genau einen tiefen, einen darauf folgenden hohen, einen darauf folgenden tiefen und einen darauf folgenden hohen Ton.

Alternativ kann ein Zyklus wenigstens oder genau einen hohen, einen darauf folgenden tiefen, einen darauf folgenden hohen und einen darauf folgenden tiefen Ton umfassen.

Als Zyklus ist z.B. eine Abfolge wie TA TÜ TA TÜ denkbar. Auch eine Abfolge wie TÜ TA TÜ TA kann einem Zyklus entsprechen.

Erfindungsgemäß ist die Steuerungsvorrichtung dazu ausgebildet, die Betriebsspannung der Tonendstufe nach einem Zyklus von einem Verstärkungsniveau in ein Grundniveau zu erniedrigen.

Um die Wahrnehmbarkeit und/oder Lautstärke zu erhöhen, kann die Steuerungsvorrichtung beispielsweise die Betriebsspannung der Tonendstufe mit jedem Zyklus in ihrer Höhe umschalten. Daraus ergibt sich eine AM-Modulation der Lautstärke.

Erfindungsgemäß ist die Steuerungsvorrichtung dazu ausgebildet, die Betriebsspannung der Tonendstufe nach einem weiteren Zyklus vom Grundniveau in das Verstärkungsniveau zu erhöhen.

Ein erster Zyklus erfolgt somit mit einer Betriebsspannung auf Verstärkungsniveau, ein zweiter Zyklus mit einer Betriebsspannung auf Grundniveau und ein dritter Zyklus mit einer Betriebsspannung auf Verstärkungsniveau. Vorzugsweise findet ein dauerhafter, zyklischer Wechsel zwischen dem Verstärkungsniveau und dem Grundniveau statt.

Erfindungsgemäß ist die Steuerungsvorrichtung dazu ausgebildet, die Betriebsspannung der Tonendstufe zwischen 12 V und 18 V zu schalten.

Die 12 V können hierbei dem Grundniveau und die 18 V dem Verstärkungsniveau entsprechen.

Vorzugsweise wird zyklisch zwischen 12 V und 18 V geschalten. So kann beispielsweise die Betriebsspannung eines Zyklus z.B. 12 V und die Betriebsspannung des darauf folgenden Zyklus z.B. 18 V betragen usw..

Nach einer weiteren Ausführungsform ist die Steuerungsvorrichtung dazu ausgebildet, einen Boostkonverter (Wandler) zu aktivieren und/oder zu deaktivieren.

Der Boostkonverter ist vorzugsweise in die Steuerungsvorrichtung integriert.

Die Leistung kann durch ein zyklisches Aktivieren und/oder Deaktivieren des Boostkonverters gesteuert werden. Dadurch wird die Versorgungsspannung der integrierten Tonendstufe, beispielsweise zwischen 12 V und 18 V, umgeschaltet.

Schließlich betrifft die Erfindung die Verwendung einer erfindungsgemäßen Sondersignalanlage bei einer Sirene und/oder einem Einsatzfahrzeug.

Bei dem Einsatzfahrzeug kann es sich beispielsweise um ein Fahrzeug mit Sonderrechten, z.B. beim Rettungsdienst, der Polizei und/oder der Feuerwehr, handeln.

Die Sondersignalanlage kann vorzugsweise dazu verwendet werden, bei einer Sirene und/oder einem Einsatzfahrzeug den maximalen Schalldruck und/oder die Wahrnehmbarkeit zu erhöhen.

Alle hier beschriebenen Aspekte, Ausführungsformen und Merkmale der Erfindung können, vorzugsweise auch losgelöst von der konkreten Ausgestaltung, in deren Zusammenhang sie erwähnt werden, jeweils miteinander kombiniert werden. Vorzugsweise können alle Gegenstände der abhängigen Ansprüche untereinander und mit dem Gegenstand des unabhängigen Anspruchs kombiniert werden.

Die Erfindung wird im Folgenden beispielhaft unter Bezugnahme auf die Zeichnung beschrieben. Es zeigt:

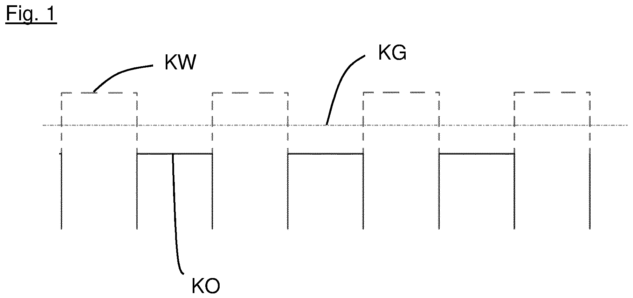

- Fig. 1: einen beispielhaften Verlauf der Leistung mit und ohne Wandler.

Zunächst ist zu bemerken, dass die dargestellte Ausführungsform rein beispielhafter Natur ist. So können einzelne Merkmale nicht nur in der gezeigten Kombination, sondern auch in Alleinstellung oder in anderen technisch sinnvollen Kombinationen realisiert sein.

In Fig. 1 zeigt die Kurve KO den Mittelwert der Leistung ohne Wandler. Dieser kann z.B. 14,1 W betragen.

Die Kurve KW, welche gestrichelt dargestellt ist, zeigt den Mittelwert der Leistung mit Wandler. Dieser kann z.B. 27,7 W betragen.

Insgesamt ergibt sich ein Gesamt-Mittelwert der Leistung, welcher mit der gepunktet dargestellten Kurve KG dargestellt ist. Dieser kann z.B. 20,9 W betragen.

### Bezugszeichenliste

- KO: Kurve des Mittelwerts der Leistung ohne Wandler
- KW: Kurve des Mittelwerts der Leistung mit Wandler
- KG: Kurve des Gesamt-Mittelwerts der Leistung

## Patentansprüche

1. Sondersignalanlage, vorzugsweise einer Sirene und/oder eines Einsatzfahrzeugs, aufweisend
zumindest einen Signaltreiber, vorzugsweise Lautsprecher,
wenigstens eine Tonendstufe, und
eine Steuerungsvorrichtung, die dazu ausgebildet ist, zur AM-Modulation der Lautstärke eine Betriebsspannung der Tonendstufe nach einem Zyklus zu verändern, wobei der Zyklus wenigstens zwei aufeinander folgende, sich in der Höhe unterscheidende Töne umfasst, wobei
die Steuerungsvorrichtung dazu ausgebildet ist, die Betriebsspannung der Tonendstufe nach einem Zyklus von einem Verstärkungsniveau in ein Grundniveau zu erniedrigen und nach einem weiteren Zyklus vom Grundniveau in das Verstärkungsniveau zu erhöhen, und wobei
die Steuerungsvorrichtung dazu ausgebildet ist, die Betriebsspannung der Tonendstufe zwischen 12 V und 18 V zu schalten.

2. Sondersignalanlage nach Anspruch 1,
**dadurch gekennzeichnet,**
**dass** ein Zyklus wenigstens oder genau einen tiefen und einen darauf folgenden hohen Ton umfasst.

3. Sondersignalanlage nach Anspruch 1,
**dadurch gekennzeichnet,**
**dass** ein Zyklus wenigstens oder genau einen hohen und einen darauf folgenden tiefen Ton umfasst.

4. Sondersignalanlage nach einem der vorhergehenden Ansprüche,
**dadurch gekennzeichnet,**
**dass** ein Zyklus wenigstens oder genau einen tiefen, einen darauf folgenden hohen, einen darauf folgenden tiefen und einen darauf folgenden hohen Ton umfasst.

5. Sondersignalanlage nach einem der Ansprüche 1 bis 3,
**dadurch gekennzeichnet,**
**dass** ein Zyklus wenigstens oder genau einen hohen, einen darauf folgenden tiefen, einen darauf folgenden hohen und einen darauf folgenden tiefen Ton umfasst.

6. Sondersignalanlage nach einem der vorhergehenden Ansprüche,
**dadurch gekennzeichnet,**
**dass** die Steuerungsvorrichtung dazu ausgebildet ist, einen Boostkonverter zu aktivieren und/oder zu deaktivieren.

7. Verwendung einer Sondersignalanlage nach einem der vorhergehenden Ansprüche bei einer Sirene und/oder einem Einsatzfahrzeug.

## Claims

1. Special signalling system, preferably of a siren and/or of an emergency vehicle, comprising
at least one signal driver, preferably a loudspeaker,
at least one audio amplifier stage, and
a control device which, for the purpose of amplitude modulation (AM) of the volume, is configured to change the operating voltage of the audio amplifier stage after a cycle, wherein the cycle comprises at least two successive tones of different pitch, wherein
the control device is configured to reduce the operating voltage of the audio amplifier stage from one amplification level to a base level after one cycle and, after a further cycle, to increase it from the base level to the amplification level, and wherein
the control device is configured to switch the operating voltage of the audio amplifier stage between 12 V and 18 V.

2. Special signalling system according to claim 1,
**characterised in that**
a cycle comprises at least or exactly one low tone and one successive high tone.

3. Special signalling system according to claim 1,
**characterised in that**
a cycle comprises at least or exactly one high tone and one successive low tone.

4. Special signalling system according to any of the preceding claims,
**characterised in that**
a cycle comprises at least or exactly one low tone, one successive high tone, one successive low tone and one successive high tone.

5. Special signalling system according to any of claims 1 to 3,
**characterised in that**
a cycle comprises at least or exactly one high tone, one successive low tone, one successive high tone and one successive low tone.

6. Special signalling system according to any of the preceding claims,
**characterised in that**
the control device is configured to activate and/or deactivate a boost converter.

7. Use of a special signalling system according to any of the preceding claims in a siren and/or an emergency vehicle.

## Revendications

1. Système de signalisation spéciale, de préférence d'une sirène et/ou d'un véhicule d'intervention, comprenant
au moins un moyen de pilotage de signal, de préférence un haut-parleur, au moins un étage audio de sortie, et
un dispositif de commande conçu pour modifier, en vue de la modulation MA de l'intensité sonore, une tension de fonctionnement de l'étage audio de sortie selon un cycle, le cycle comprenant au moins deux sons successifs qui se distinguent par leur hauteur,
dans lequel
le dispositif de commande est conçu pour, après un cycle, abaisser la tension de fonctionnement de l'étage audio de sortie pour la faire passer d'un niveau d'amplification à un niveau de base, et pour, après un autre cylindre, l'augmenter pour la faire passer du niveau de base au niveau d'amplification, et
le dispositif de commande est conçu pour commuter la tension de fonctionnement de l'étage audio de sortie entre 12 V et 18 V.

2. Système de signalisation spéciale selon la revendication 1,
**caractérisé en ce que**
un cycle inclut au moins ou exactement un son grave et un son aigu successif.

3. Système de signalisation spéciale selon la revendication 1,
**caractérisé en ce que**
un cycle inclut au moins ou exactement un son aigu et un son grave successif.

4. Système de signalisation spéciale selon l'une des revendications précédentes,
**caractérisé en ce que**
un cycle inclut au moins ou exactement un son grave, un son aigu successif, un son grave successif et un son aigu successif.

5. Système de signalisation spéciale selon l'une des revendications 1 à 3,
**caractérisé en ce que**
un cycle inclut au moins ou exactement un son aigu, un son grave successif, un son aigu successif et un son grave successif.

6. Système de signalisation spéciale selon l'une des revendications précédentes,
**caractérisé en ce que**
le dispositif de commande est conçu pour activer et/ou désactiver un convertisseur survolteur.

7. Utilisation d'un système de signalisation spéciale selon l'une des revendications précédentes dans une sirène et/ou un véhicule d'intervention.
